Europäisches Patentamt

European Patent Office

Office européen des brevets

(11) Publication number: **0 363 100**
A2

## EUROPEAN PATENT APPLICATION

(21) Application number: 89309978.8

(22) Date of filing: 29.09.89

(51) Int. Cl.⁵: **B24B 1/00** , **H01L 21/306** , **H01L 21/76** , **H01L 21/321**

(30) Priority: 02.10.88 JP 247819/88
29.09.89 JP 255503/89

(43) Date of publication of application:
**11.04.90 Bulletin 90/15**

(84) Designated Contracting States:
**DE FR GB NL**

(71) Applicant: **CANON KABUSHIKI KAISHA**
**30-2, 3-chome, Shimomaruko**
**Ohta-ku Tokyo(JP)**

(72) Inventor: **Yanehara, Takao**
**2235-1, Nurumizu**
**Atsugi-shi Kanagawa-ken(JP)**

(74) Representative: **Beresford, Keith Denis Lewis**
**et al**
**BERESFORD & Co. 2-5 Warwick Court High**
**Holborn**
**London WC1R 5DJ(GB)**

(54) **Selective polishing method.**

(57) A selective polishing method comprises polishing the surface of a body to be polished having a region comprising $Si_3N_4$ and a region comprising a material more easily workable than said $Si_3N_4$ provided with a difference in height with the surface of the region comprising said more easily workable material being made higher with an abrasive comprising colloidal silica or an abrasive comprising colloidal silica as the solute and water as the solvent.

FIG. 4A

FIG. 4B

FIG. 4C

FIG. 4D

EP 0 363 100 A2

## Selective Polishing Method

BACKGROUND OF THE INVENTION

Field of the Invention

This invention relates to a polishing method which polishes the surface of a body to be polished. The present invention relates to a polishing method which, for example, flattens a semiconductor layer.

Related Background Art

It has been known effective for improvement of its device performance to make the semiconductor layer on an insulating material such as SOI layer thinner and flat as described in the previous meeting of International Workshop on Future Electron Devices, 1988, and there have been proposed the three methods for obtaining such thin layer. One is the method in which the upper part of Si layer is oxidized and removed with an acid type etchant (the oxidized layer-removing method), the second is the method to make the layer thinner by reactive ion etching, and the third is the selective mechanochemical polishing method which utilizes remarkable difference in polishing speed between Si and SiO2 by incorporation of a special chemical polishing liquid (Hamaguchi, Endo, Japanese Journal of Applied Physics Vo. 56, No. 11, p. 1480; T. Hamaguchi. N. Endo, M. Kimura and A. Ishitani, Japanese Journal of Applied Physics Vol. 23, No. 10, 1984 PD.L - 815; T. Hamaguchi, N. Endo, M. Kimura and M. Nakamae, Proceeding of International Electron Device Meeting, p. 688, 1985, Washington D.C., U.S.A.).

The oxidized layer-removing method must use a method such as high pressure oxidation, etc. for accelerating the oxidation rate, which becomes a very expensive process. In addition, when unevenness exists on the starting material surface, first it must be flattened by some method before oxidation.

Further, when a grain boundary or a crystal with different direction exists in the Si layer, many problems are involved in uniform, flat oxidation due to accelerated oxidation along the grain boundary or anisotropy in oxidation rate depending on the crystal direction.

On the other hand, the reactive ion etching method which is the second method cannot choose but control the thickness by controlling the etching time for making thinner the thickness to a desired one, but many problems are involved in controllability, reproducibility, uniformness, and mass productivity thereof for controlling a large area substrate precisely with a thickness of 1 μm or less. Further, the point to be added is collision against the surface of the ions having an energy by direct incidence on the· semiconductor crystal, whereby there also remains the problem doing damage to the very surface layer.

As for the final mechanochemical polishing method, for example, general mechanochemical polishing techniques for silicon wafer use abrasive grains of $SiO_2$ with diameters of about 0.01 μm called colloidal silica suspended in a weakly alkaline chemical liquid as an abrasive. And, as the polishing cloth, a polyurethane type cloth is used to perform polishing. Mechanochemical polishing has physical polishing action through friction between abrasive grains ($SiO_2$) and the silicon water and the chemical dissolving action of silicon into the weakly alkaline polishing liquid through the exothermic temperature elevation during the friction existing mixedly. Mechanochemical polishing has been used in the final step when polishing a substrate such as silicon wafer, etc., and when a silicon wafer is polished, a mirror surface is obtained.

In the above report (Hamaguchi, Endo. Japanese Journal of Applied Physics Vol. 56, No. 11, p. 1480), the selective polishing method is shown. Here, a special chemical liquid is used as the working liquid, and said method consists of the chemical removing process by use of the chemical reaction between the chemical solution and silicon, and the mechanical removing process of wiping off the substance formed by said chemical reaction by means of a polishing cloth. For example, when Si is etched by use of ethylenediamine pyrocatechol, $Si(OH)_6^{2-}$ are formed on the Si surface by the ionization reaction of the amine and the redox reaction, which are dissolved into the liquid through formation of a chelate with the pyrocatechol. And, in the selective polishing, $Si(OH)_6^{2-}$ formed by the chemical reaction is wiped off with a polishing cloth.

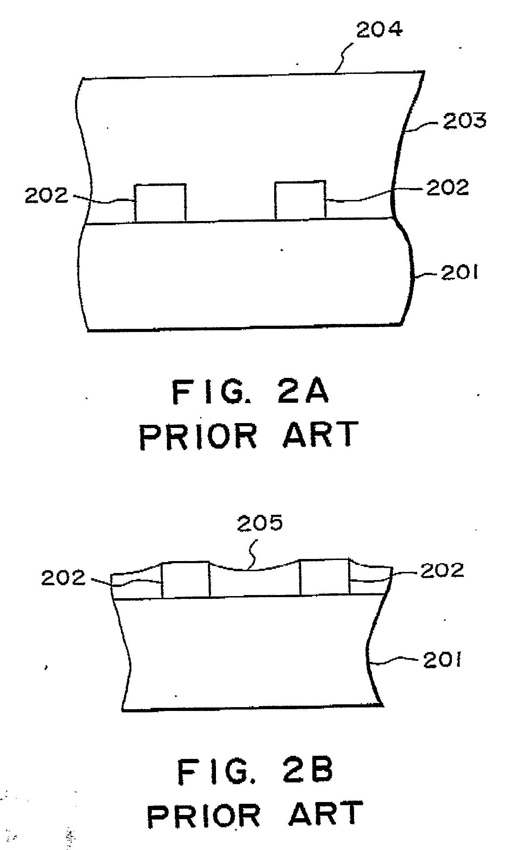

However, also in the mechanochemical polishing method as described above, there are problems as described below These problems are described bv referring to Fig. 2. Fig. 2 is a schematic sectional view for illustration of the mechanochemical polishing method of the prior art.

In Fig. 2A, a SiO₂ region 202 is formed on a silicon substrate 201, and further a silicon layer 203 is formed thereon. 204 is a silicon layer surface. As the abrasive, one comprising colloidal silica added with ammonia water which has been used in the prior art was used.

As the result of polishing according to this polishing method, the silicon layer surface 205 became concave in shape, thus being polished in a recessed state deeper by 0.2 $\mu$m than the SiO₂ region 202, as shown in Fig. 2B. The recess to such extent poses little problem in the case when the silicon layer is relatively thick. However, for example, when it is demanded to make the film of the device thinner for making greater the channel conductance of the channel region of the transistor, the recess as described above was not preferable in effecting improvement of performance of the device.

## SUMMARY OF THE INVENTION

An object of the present invention is to overcome various problems as described above and to provide a selective polishing method which can polish a thin layer extremely flat regardless of its crystal structure and also make the layer thinner with good precision (to 1 $\mu$m or less).

Another object of the present invention is to provide a selective polishing method which makes a semiconductor layer such as SOI layer (silicon over insulator) on an insulating material thinner so as to be useful for formation of device and useful for making higher performances of device.

Still another object of the present invention is to provide a selective polishing method which can effect flattening of a thin layer by a simple method with good precision.

Still another object of the present invention is to provide a selective polishing method, which comprises polishing the surface of a body to be polished having a region comprising Si₃N₄ and a region comprising a material more easily workable than said Si₃N₄ provided with a difference in height with the surface of the region comprising said more easily workable material being made higher with an abrasive comprising colloidal silica or an abrasive comprising colloidal silica as the solute and water as the solvent.

## BRIEF DESCRIPTION OF THE DRAWINGS

Figs. 1A and 1B are schematic illustrations for explanation of the outline of the present invention;

Figs. 2A and 2B are schematic illustrations for explanation of the outline of the mechanochemical polishing of the prior art;

Fig. 3 is a schematic illustration of a surface polishing apparatus used in the present Examples;

Figs. 4A through Fig. 6C are schematic illustrations for explanation of the outline of the polishing method in the process to reach the present invention;

Figs. 7A through 9B are schematic illustrations for explanation of the Examples of the present invention.

## DETAILED DESCRIPTION OF THE PREFERRED EMBODIMENT

A preferred embodiment of the selective polishing method of the present invention is as described below.

The present method comprises polishing the surface of a body to be polished having a region comprising Si₃N₄ and a region comprising a material more easily workable than said Si₃N₄ provided with a difference in height with the surface of the region comprising said more easily workable material being made higher with an abrasive comprising colloidal silica or an abrasve comprising colloidal silica as the solute and water as the solvent.

Alternatively, another embodiment comprises polishing the surface of a body to be polished having a region comprising a material having a Mohs' hardness of 9 or higher and a region comprising a material more easily workable than the material having a Mohs' hardness of 9 or higher provided with a difference in height with the surface of the region comprising said more easily workable material being made higher with an abrasive comprising colloidal silica or an abrasive comprising colloidal silica as the solute and water as the solvent.

According to the present invention with the above constitution, by use of an abrasive comprising only colloidal silica or an abrasive comprising colloidal silica as the solute and only water as the solvent, the difficulty in flattening due to the acceleration etching phenomenon by the chemical polishing method can be overcome. Further, by depositing a thin film to be polished on a substrate having a region comprising Si₃N₄

3

with high hardness relative to the above abrasive and extremely low acceleration speed to a desired height (thickness) on the substrate surface before polishing, polishing can be completed at the point when the region with high hardness ($Si_3N_4$) appears, whereby a thin layer with good precision not depending on the variance on the thickness of the substrate can be provided.

The abrasive as mentioned in the present invention is not limited to abrasive particles used for polishing, but also includes working liquids.

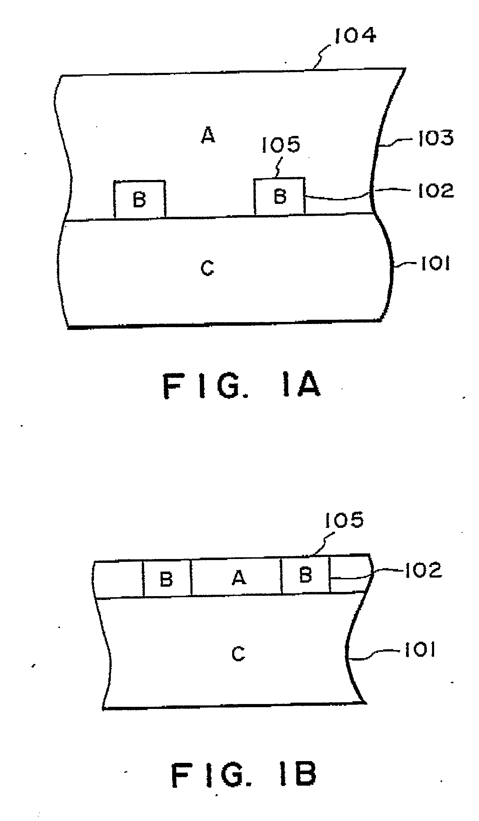

The outline of the present invention is to be explained by referring to Figs. 1A and 1B. Fig. 1A shows a sectional view of the structure before polishing. On the surface of the substrate 101, a thin film comprising $Si_3N_4$ (silicon nitride) B is formed and regions 102 are previously formed by patterning, etc. Subsequently, a thin film 103 comprising a material A is deposited so as to cover the above substrate 101 and the $Si_3N_4$ region 102. The thin film 103 comprising the material A is made one readily polishable with the abrasive comprising only colloidal silica or the abrasive comprising colloidal silica as the solute and only water as the solvent, for example, silicon. In Fig. 1B, when polishing is carried out by use of the above abrasive, the thin layer 103 can be polished flat regardless of its crystal structure by stopping polishing by having the surface 105 of the region 102 exposed on the surface. Here, the region 102 becomes the stopper of polishing.

The relationships between the hardness K of the abrasive, the hardness K (A) of the material (A) to be polished, and the hardness K (B) of the stopper (B) are as follows:

K (A) $\leq$ K

K (B) > K.

In practical polishing, the etching components contained in the abrasive, the kind of the polishing cloth, pressure, and temperature are mutually related to each other, and the value of K does not become the value of the abrasive substance itself, but is variable depending on other conditions.

Here, description is made about how the present invention has been reached.

As previously described, when polishing is performed by use of the selective polishing method of the prior art, a recess has been inevitably formed at the central portion of the silicon layer sandwiched between $SiO_2$. And, for a semiconductor device, for which thin layer formation of silicon layer is demanded, a bad product is formed at the point when the silicon layer has been polished.

The present inventors have successfully reduced recesses in the central portion of the silicon layer sandwiched between $SiO_2$ stoppers by removing ammonia water, which is the chemical etching component, from the abrasive in the selective polishing method of the prior art.

In the following, Comparative examples, in which polishing was performed by use of only colloidal silica by removing ammonia from the abrasive of the prior art (colloidal silica + ammonia water) are shown.

## Comparative example 1

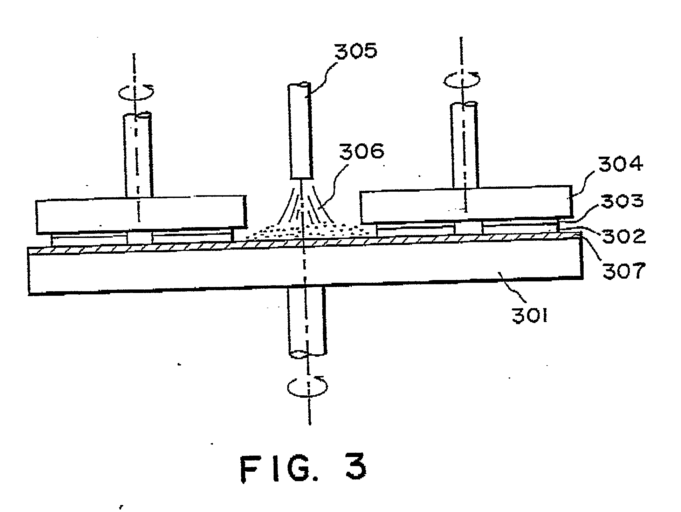

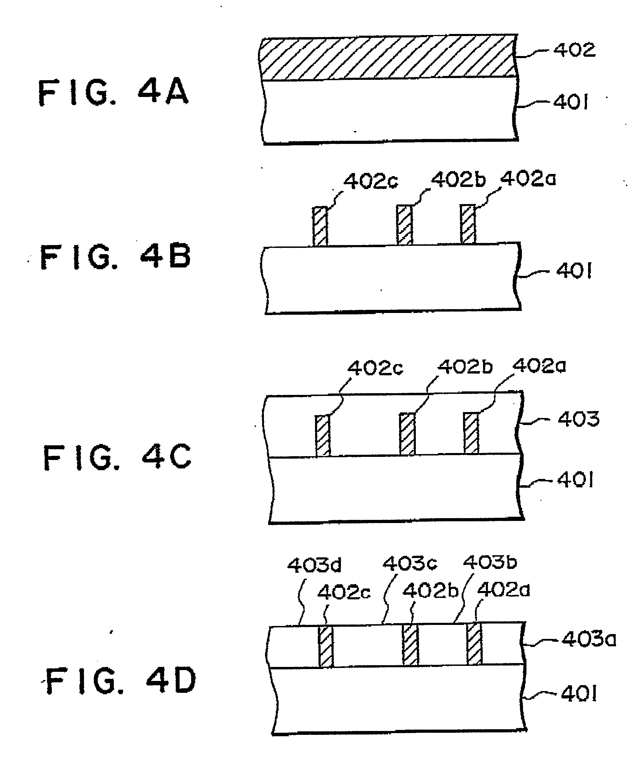

Description is made by referring to Fig. 4. On the surface of a Si single crystalline substrate 401 having the (100) planar direction, a thermally oxidized film ($SiO_2$) 402 with a thickness of 5,000 Å was formed (see Fig. 4A). Then, patterning was effected at intervals or 10 $\mu$m to form a stopper with regions 402a - 402c comprising $SiO_2$ of 0.5 $\mu$m square of one side remaining on the Si substrate 401. Thermal oxidation was carried out at 950 °C in dry atmosphere (see Fig. 4B). On the substrate 401 processed as shown in Fig. 4B), Si crystal layer 403 was grown to a thickness of 1.5 $\mu$m according to the selective epitaxial growth method. Crystal formation conditions were according to the hot CVE, under a pressure of 100 Torr, at a crystal formation temperature of 900 °C and by use of $SiH_2Cl_2/H_2/HCl$ as the gases, at flow rates of the respective gases of 0.53 $\ell$/min, 100 $\ell$/min and 1.6 $\ell$/min (see Fig. 4C). Subsequently, with the sample shown in Fig. 4C mounted on one surface polishing apparatus shown in Fig. 3, by use of an abrasive comprising only colloidal silica (average particle size 0.01 $\mu$m), polishing was carried out under a pressure of about 220 g/cm², at a temperature ranging from 30 to 40 °C for 12 minutes. As the polishing cloth, an artificial leather was used. The analytical results of the colloidal silica used here are as shown in Table 1. Thus, the colloidal silica used in this Comparative example has a composition containing only 95.3 % of $SiO_2$ and also containing components having etching action as the components other than this component. The colloidal silica to be used in the present invention should preferably comprised 80 % or more of $SiO_2$, more preferably 90 % or more of $SiO_2$.

4

Table 1

| SiO$_2$ | 95.3% |
|---|---|
| Ig | 3.8 |
| Al$_2$O$_3$ | 0.55 |
| Fe$_2$O$_3$ | 0.04 |
| TiO$_2$ | 0.09 |
| CaO | 0.05 |
| MgO | 0.01 |
| Na$_2$O | 0.30 |
| SO$_4$ | 0.05 |
| Cl | 0.01 |

A specific polishing method is described by referring to Fig. 3. Fig. 3 is a schematic sectional view showing one surface polishing apparatus. First, the sample 302 shown in Fig. 4C is plastered on a plastering block 304 by use of a wax 303 used for conventional plastering of silicon wafer. Next, while supplying an abrasive (colloidal silica) 306 through a working liquid supplying inlet 305, a rotatory table 301 was rotated by rotating the rotational shaft 309. It is devised that the block 304 also rotates by rotation of the rotatory table 301. 308 is a rotational shaft. The rotatory table 301 is mounted with an artificial leather 307, and polishing was performed by rotating the rotatory table while applying a pressure of 220 g/cm$^2$ between the sample 302 and the polishing cloth 307.

The results after polishing here for 2 minutes are to be described. As shown in Fig. 4D, the Si layer 403 was polished to about 1 $\mu$m by polishing for 10 minutes, whereby the surfaces of the SiO$_2$ regions 402a, 402b, 402c appeared. Subsequently, polishing was performed for 2 minutes. As the result, the Si layer with a thickness of 0.48 $\mu$m was polished uniformly with the 4 inch wafer at a precision of ± 8 %. The working speeds of the Si layer and the thermally oxidized SiO$_2$ region were respectively 0.1 $\mu$m/min and 0.004 $\mu$m/min.

When only colloidal silica is used as the abrasive particles, etching speed on the Si layer surface becomes lower and the concave shape of the Si layer surface formed when using abrasive particles comprising colloidal silica added with ammonia became extremely small.

Comparative example 2

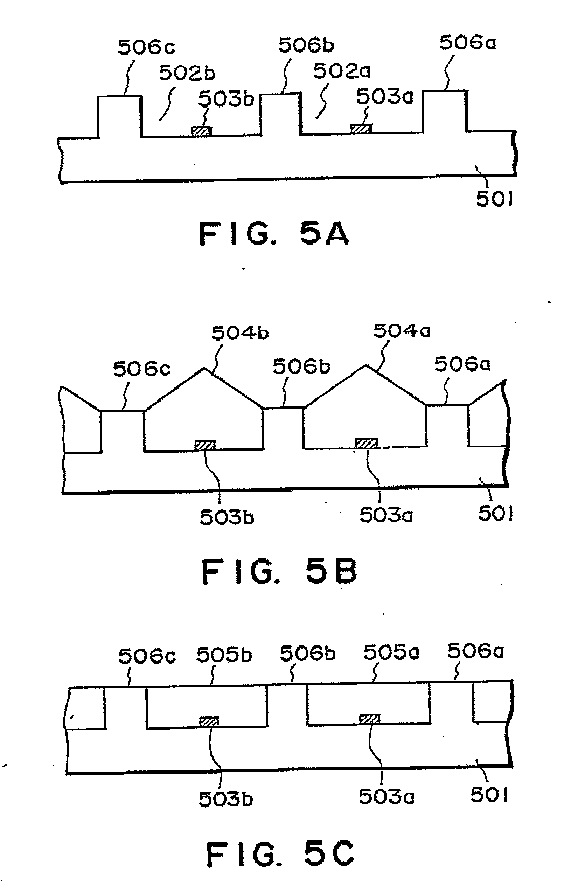

Figs. 5A - 5C show a comparative example in a body to be polished of the SOI structure. On a quartz substrate 501 were formed concavities 502a and 502b with a square shape of a depth of 1,000 Å and low area 5 $\mu$m x 5 $\mu$m by photolithography. Subsequently, a Si$_3$N$_4$ layer was deposited to 100 Å by LPCVD. At this time, as the starting gases, SiH$_2$Cl$_2$ and NH$_3$ were employed at flow rates respectively of 20 cc/min and 80 cc/mn. Then, the regions 503a and 503b comprising Si$_3$N$_4$ of 1 $\mu$m square were formed at the center of the concavities 502a and 502b according to the patterning working treatment (see Fig. 5A). The substrate was set in a CVD device and subjected to the crystal formation treatment in a gaseous system of 150 Torr, 950 °C, SiH$_2$Cl$_2$/HCl/H$_2$ ( = 0.53 ($\ell$/min)/1.6 ($\ell$/min)/100 ($\ell$/min)). Then, single nuclei of Si were formed only on the Si$_3$N$_4$ regions 503a and 503b, whereby Si single crystals 504a and 504b with shapes having facets protruded about 4.5 $\mu$m from the concavities embedded the concavities as shown in Fig. 3B.

Then, polishing was carried out under the conditions shown in Comparative example 1 for 30 minutes. After polishing for 25 minutes, the side wall surfaces of the side wall portions 506a, 506b and 506c of the substrate 501 appeared as shown in Fig. 5C. Subsequently, by performing polishing for 5 minutes, a flat Si thin layer of 800 Å ± 70 Å was obtained on the 4 inch substrate. In the case of Comparative example 1, the Si single crystal had a single crystal direction, but in this Example, the substrate was amorphous and no long distance order could be obtained, and therefore there existed some variance in the directions of the respective crystal islands. Nevertheless, a thin layer with a uniform thickness as compared with the prior art was obtained after polishing.

Comparative example 3

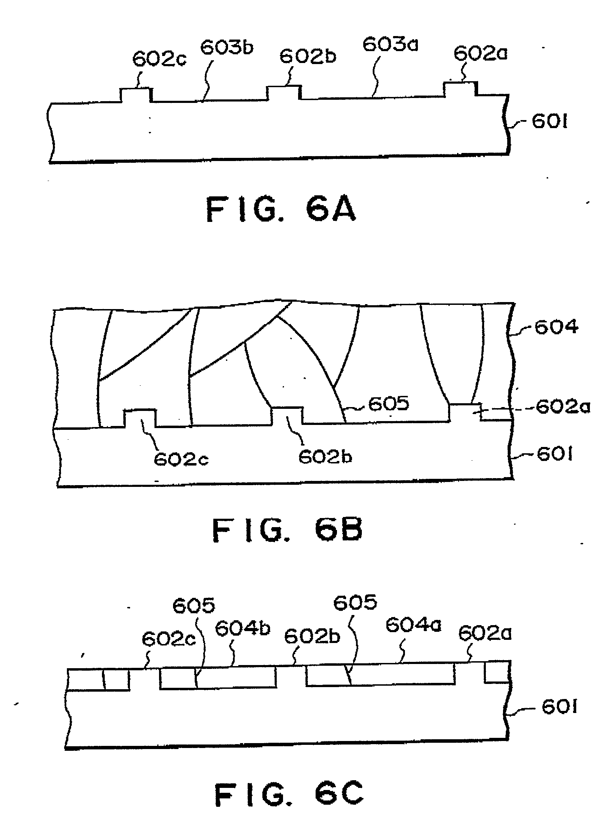

By use of Fig. 6, an example is shown, in which concavities 603a and 603b were directly provided on a quartz substrate 601 and the surface of polycrystalline Si layer was polished flat. On the surface of the quartz surface 601, 50 x 50 of concavities 603a and 603b of 1,000 Å x 5 μm x 5 μm were provided by use of a photolithography and reactive ion etching (Fig. 6A).

Then, a polycrystalline Si layer having an average grain size of 3 μm was formed within a CVD device as described below. More specifically, when formed for 5 minutes under the conditions of 960 °C, 15 Torr, $SiH_2Cl_2/HCl/H_2$ ( = 0.53 (ℓ/min)/1.1 (ℓ/min)/100 (ℓ/min)), a Si polycrystalline layer 604 with a thickness of 5 μm was obtained (Fig. 5B). Next, when polishing was performed for 50 minutes under the same conditions as used in Comparative example 1, the surfaces of the convexities 602a, 602b and 602c appeared. Subsequently, polishing was performed for 5 minutes. Consequently, flat polishing was effected with a precision of 800 Å ± 70 Å to form Si polycrystalline bodies 604a and 604b. 605 shows the grain boundary.

From Comparative examples 1 to 3, it can be seen that uniformity of the layer thickness of the polished Si layer is increased by using as the abrasive only colloidal silica reduced in etching components from the abrasive of the prior art (colloidal silica + ammonia water).

However, in the polishing method shown in Comparative examples, particularly when forming a semiconductor device by use of a semiconductor layer with a layer thickness of 1000 Å or less, further improvement with respect to yield of good product was required.

The present inventors have made further studies and consequently found that a dramatic effect can be obtained by carrying out selective polishing by use of an abrasive comprising only colloidal silica or an abrasive comprising colloidal silica as the solute and water as the solvent, and by use of $Si_3N_4$ as the stopper.

In the following, Examples of the present invention are shown.

Example 1

Except that the stopper was formed of $Si_3N_4$ in place of $SiO_2$, the Si layer surface was polished in the same manner as used in Comparative example 1. $Si_3N_4$ was deposited to a film thickness of 5,000 Å according to the LPCVD at 0.3 Torr, 800 °C. At this time, the gases employed were $OiH_2Cl_2$ and $NH_3$ at flow rates of 20 cc/min and 8 cc/min, respectively. Then, Si was epitaxially grown, following subsequently similarly Comparative example 1. Then, when polishing was carried out under the same conditions as used in Example 1, the working speed of $Si_3N_4$ was substantially 0 (zero) due to its high hardness (Mohs' hardness 9). And, when polishing was performed for 2 minutes after $Si_3ON_4$ region had appeared, the Si layer of 0.5 μm thickness could be flattened and made thinnner with a precision of ± 5 % within the 4 inch wafer.

In the present invention, as the stopper, $Al_2O_3$ or SiC with a Mohs' hardness of 9 or higher can be also used.

Example 2

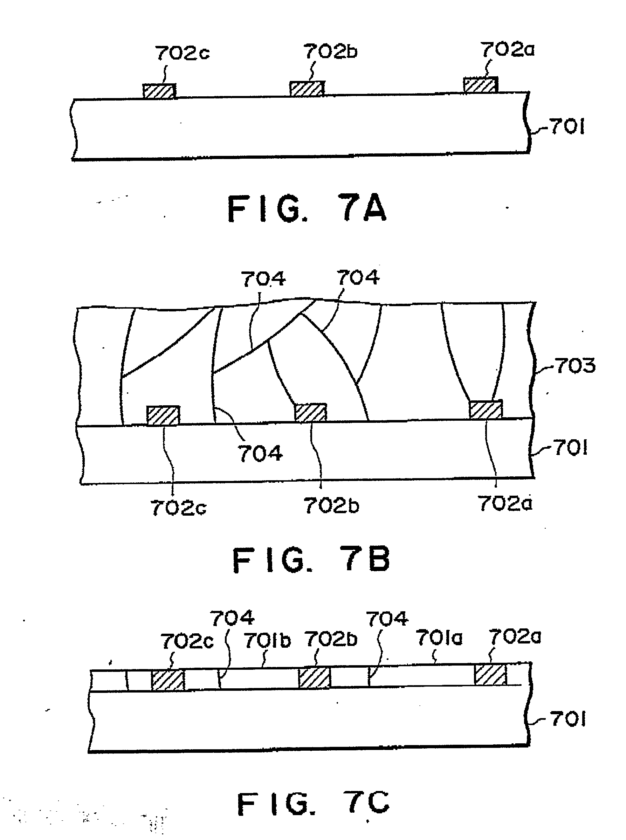

A polishing example of a polycrystalline Si is described by referring to Fig. 7.

On a quartz substrate 701 was deposited a $Si_3N_4$ film to a thickness of 800 Å, and a plurality of regions 702a, 702b and 702c of 10 μm x 10 μm comprising $Si_3N_4$ were formed by use of photolithography and etching as shown in Fig. 7A.

Then, a polycrystalline Si layer having an average grain size of 3 μm was formed within a CVD device as described below. More specifically, when a film was formed for 5 minutes under the conditions of 960 °C, 15 Torr, $SiH_2Cl_2/HCl/H_2$ ( = 0.53 (ℓ/min)/1.1 (ℓ/min)/100 (ℓ/min)), an Si polycrystalline layer 703 with a thickness of 5 μm was obtained. 704 shows a crystal grain boundary (Fig. 7B). Next, when the same polishing as used in Example 1 was carried out on the layer for 50 minutes, the $Si_3N_4$ regions 702a, 702b and 702c appeared. Subsequently, by performing polishing for 2 minutes, Si polycrystalline ultra-thin films 701a, 701b and 701c of 800 Å ± 40 Å were obtained at large area of 25 cm x 10 cm (Fig. 7C).

Example 3

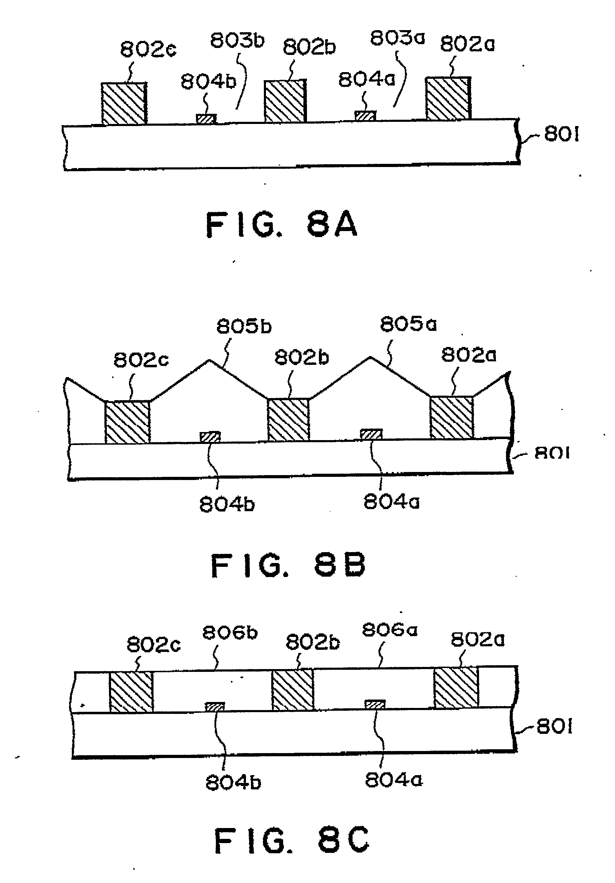

Description is made by referring to Fig. 8. First, for forming side wall portions 802a, 802b and 802c, an $Si_3N_4$ film was formed according to the LPCVD method on a flat $SiO_2$ substrate 801. At this time, $SiH_2Cl_2$

and $NH_3$ were employed as the starting gases, and film was formed at a pressure of 800 °C for 30 minutes. Subsequently concavities 803a and 803b of 1,000 Å x 5 $\mu$m x 5 $\mu$m were formed by patterning working.

Next, on the above concavity was deposited a polycrystalline Si film to 500 Å by LPCVD and subjected to patterning to a 0.5 $\mu$m diameter to form a polycrystalline Si region. Then, by the solid phase agglomeration reaction according to the heat treatment carried out at 1,000 °C in $H_2$ for 3 minutes, the polycrystalline Si region was denatured to single crystalline Si regions 804a and 804b. By use of these as seed crystals, crystal formation was carried out by CVD under the conditions of 150 Torr, 950 °C, $SiH_2Cl_2/HCl/H_2$ ( = 0.53 ($\ell$/min)/2,2 ($\ell$/min)/100 ($\ell$/min)). As the result, as shown in Fig. 8B, no nucleus of Si was generated on the surfaces of $Si_3N_4$ surface side walls 802a, 802b and 802c on the $SiO_2$ substrate 801, but Si single crystals 805a and 805b were grown only from the central Si seed crystals, and they were finally grown until embedding the concavities 802a and 803b and the facets emerging to above the concavities 803a and 803b.

At this time, by charging HCl in an amount slightly larger than in Example 1, the nucleus generation in the $Si_3N_4$ region could be effectively inhibited. Then, when polishing was carried out for 25 minutes under the same conditions as used in Example 1, side walls 802a, 802b and 802c having a height of 1,000 Å appeared. Subsequently, by performing polishing for 2 minutes, very thin Si layers 806a and 806b of 1,000 Å ± 20 Å were obtained uniformly within the 4 inch wafer.

## Example 4

Film formation and polishing were performed under the same conditions as used in Example 1 except for using colloidal silica added with water as the abrasive. As the result, the Si layer having a thickness of 0.5 $\mu$m could be made thinner at a precision of ± 5 % within the 4 inch wafer.

## Example 5

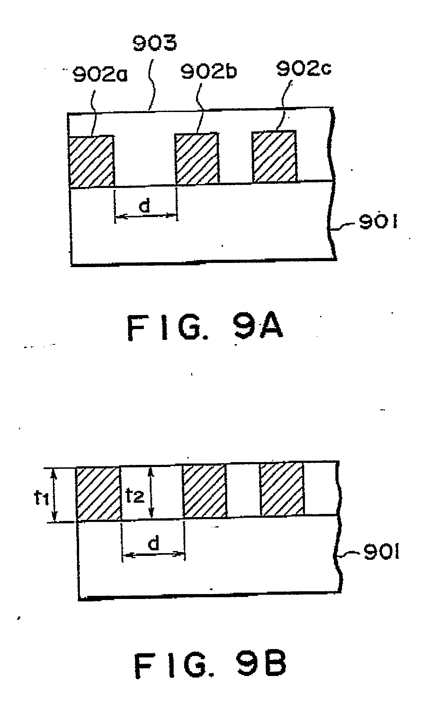

For the case of employing $SiO_2$ as the stopper and the case of employing $Si_3N_4$, the recess on the semiconductor surface was evaluated, respectively. Description is made by referring to Fig. 9.

On an Si single crystal substrate 901, $SiO_2$ stoppers 902a, 902b and 902c of 1 $\mu$m square were prepared according to the method as described in Comparative examples by varying variously the distance d between the stoppers. Next, an Si epitaxial layer 903 was formed (Fig. 9A). Subsequently, polishing was performed in the same manner as used in Example 1 (see Fig. 9B).

The polished sample was worked to make its cross-section visible, and evaluated by use of SEM. As the evaluation method, the yield of good product was measured by evaluating the product satisfying the following relationship between $t_1$ (thickness of stopper after polishing) and $t_2$ (thickness of semiconductor layer after polishing) as good product. Here, $t_2$ is a value obtained by measuring the thickness of the central portion between stoppers.

$t_1 - t_2 \leq 0.005 \, t_1 -$

For $Si_3N_4$ stoppers, they were prepared according to the method shown in the previous Examples. After samples were polished under the same conditions as used in the case of employing $SiO_2$ stopper, the polished surfaces were evaluated according to the same methods as in the case of employing $SiO_2$ stoppers. Yields of good products when employing $SiO_2$ and $Si_3N_4$ as the stopper are shown in Table 2.

In the case of $SiO_2$, the yield of good product is abruptly lowered as the distance d between the stoppers becomes larger, while in the case of $Si_3N_4$, the yield of good product is lowered gently even if the distance d may become larger. Particularly, if the value of d becomes 30 $\mu$m or more, the yield is lowered to 50 % or lower in the case of $SiO_2$, while in the case of $Si_3N_4$, 100 % yield is maintained up to the d value of 30 $\mu$m. Thus, it can be appreciated that uniform semiconductor polished surface can be obtained by use of $Si_3N_4$ as the stopper. From this Example, the value of d may be preferably 50 $\mu$m or less, more preferably 40 $\mu$m or less, most preferebly 30 $\mu$m or less. By use of $Si_3N_4$ as the stopper, a semiconductor device with larger area than in the case of using $SiO_2$ as the stopper can be obtained.

Table 2: Yield of good product (%)

| d($\mu$m) / Stopper | 5 | 10 | 15 | 20 | 25 | 30 | 35 | 40 | 45 | 50 | 55 | 60 | 65 | 70 |
|---|---|---|---|---|---|---|---|---|---|---|---|---|---|---|
| $SiO_2$ | 85 (%) | 80 | 75 | 75 | 60 | 50 | 45 | 45 | 40 | 40 | 30 | 25 | 15 | 10 |
| $Si_3N_4$ | 100 (%) | 100 | 100 | 100 | 100 | 100 | 95 | 95 | 80 | 80 | 70 | 60 | 30 | 45 |

As described above, according to the present invention, for example, in the case of polishing a semiconductor layer, the semiconductor layer can be made flat and thinner with good precision regardless of its crystal structure. As the result, for example, polishing of a semiconductor layer for device formation, for which insulation separation and ultra-thin layer formation (< 1,000 Å) of devices are demanded, can be effected at high yield.

**Claims**

1. A selective polishing method, which comprises polishing the surface of a body to be polished having a region comprising $Si_3N_4$ and a region comprising a material more easily workable than said $Si_3N_4$ provided with a difference in height with the surface of the region comprising said more easily workable material being made higher with an abrasive comprising colloidal silica or an abrasive comprising colloidal silica as the solute and water as the solvent.

2. A selective polishing method according to claim 1, wherein the material for forming the region comprising more easily workable material is silicon.

3. A selective polishing method according to claim 1, wherein a plurality of said region comprising $Si_3N_4$ is provided, and the distance between the regions comprising said $Si_3N_4$ is 50 $\mu$m or less.

4. A selective polishing method according to claim 1, wherein the composition of said colloidal silica contains 80 % or more of $SiO_2$.

5. A selective polishing method, which comprises polishing the surface of a body to be polished having a region comprising a material having a Mohs' hardness of 9 or higher and a region comprising a material more easily workable than the material having a Mohs' hardness of 9 or higher provided with a difference in height with the surface of the region comprising said more easily workable material being made higher with an abrasive comprising colloidal silica or an abrasive comprising colloidal silica as the solute and water as the solvent.

6. In a method of manufacturing a semi-conductor device of a kind which includes the step of polishing a semi-conductor layer down to the level of the top of an element embedded in the layer, the polishing being characterised in that it is carried out using an abrasive medium which does not contain any etching ingredient.

7. A semi-conductor produced by the method as claimed in any previous claim.

F I G. IA

F I G. IB

FIG. 2A
PRIOR ART

FIG. 2B
PRIOR ART

FIG. 3

FIG. 4A

402

401

FIG. 4B

402c    402b  402a

401

FIG. 4C

402c    402b   402a

403

401

FIG. 4D

403d    403c    403b
402c    402b    402a

403a

401

506c    502b
          503b          506b    502a
                                  503a          506a

501

# FIG. 5A

504b              504a
506c         506b              506a

503b         503a          501

# FIG. 5B

506c  505b    506b    505a    506a

503b         503a      501

# FIG. 5C

602c  603b  602b  603a  602a

601

FIG. 6A

604

605

602a

602c  602b

601

FIG. 6B

605  605

602c  604b  602b  604a  602a

601

FIG. 6C

702c          702b              702a

—701

# FIG. 7A

704        704

—703

704

—701

702c              702b              702a

# FIG. 7B

704            704
702c   701b 702b        701a   702a

—701

# FIG. 7C

FIG. 8A

FIG. 8B

FIG. 8C

**FIG. 9A**

**FIG. 9B**